# EUROPEAN PATENT APPLICATION

(11) **EP 4 832 745 A1**
(43) Date of publication of application: **28.10.2026**
(21) Application number: 26170928.1
(22) Date of filing: 07.04.2026
(51) Int. Cl.: H10W 90/10, H10W 90/00, H10W 90/20

(54) **SEMICONDUCTOR PACKAGE AND PRINTED CIRCUIT BOARD ASSEMBLY**

(30) Priority: 11.04.2025 US 202563787252 P; 11.04.2025 US 202563787256 P; 06.04.2026 US 202619640397
(71) Applicant: MediaTek Inc., Hsinchu City 30078 (TW)
(72) Inventor: KUMAR, Arvind, San Jose, 95134 (US); KOLLURU, Krishna Bharath, San Jose, 95134 (US); NALAMALPU, Ankireddy, San Jose, 95134 (US); KUMASHIKAR, Mahesh K., San Jose, 95134 (US); SUBBAREDDY, Dheeraj Reddy, San Jose, 95134 (US); GADEY, Siva, San Jose, 95134 (US)
(74) Representative: Hoefer & Partner Patentanwälte mbB

(57) **Abstract**

A semiconductor package (100) includes a package substrate (102), an interposer (104), a first component (106), and a second component (110). The interposer (104) is mounted on the package substrate (102). The first component (106) is mounted on the interposer (104) and located on an edge of the interposer (104). The first component (106) is an optical chiplet (i.e., a co-packaged optics chiplet) or a co-packaged connector. The second component (110) is mounted on the package substrate (102). The second component (110) on the package substrate (102) is adjacent to the edge of the interposer (104).

## Description

### Field of the Invention

The present disclosure relates to an integrated circuit (IC) design, and more particularly, to a memory stacking scheme employed by a semiconductor package and a printed circuit board (PCB) assembly.

### Background of the Invention

Advanced packaging refers to a set of semiconductor integration technologies that go beyond traditional wire bonding and flip chip packages, enabling higher bandwidth, lower power, smaller form factor, and heterogeneous integration of multiple dies. For example, an interposer is mounted on a package substrate, and compute dies, input/output (IO) chiplets, and high bandwidth memories (HBMs) can be mounted on the interposer. The IO chiplet is generally located on an edge of the interposer, and requires IO signal routing to traverse the interposer and the package substrate for IO communications with other semiconductor packages mounted on a PCB. As a result, a dynamic random access memory (DRAM) cannot be placed on an area of the package substrate that is adjacent to the edge of the interposer because of the IO signal traces routed in the package substrate. In addition, the interposer only allows a limited number of memory chips (e.g., HBMs) mounted thereon. Thus, there is a need for an innovative memory stacking scheme to address these issues.

### Summary of the Invention

This in mind, the present invention aims at providing a memory stacking scheme employed by a semiconductor package and a PCB assembly.

This is achieved by a semiconductor package and a PCB assembly according to independent claims. The dependent claims pertain to corresponding further developments and improvements. The scope of the invention is defined by the appended sets of claims.

As will be seen more clearly from the detailed description following below, the claimed semiconductor package includes a package substrate, an interposer, a first component, and a second component. The interposer is mounted on the package substrate. The first component is mounted on the interposer, and located on an edge of the interposer. The first component is an optical chiplet (i.e., a co-packaged optics (CPO) chiplet) or a co-packaged connector (CPC). The second component is mounted on the package substrate. The second component on the package substrate is adjacent to the edge of the interposer.

The claimed semiconductor package includes a package substrate, an interposer, a first memory, a second memory, and a compute die. The interposer is mounted on the package substrate. The first memory is mounted on the package substrate. The second memory is mounted on the interposer. The first memory and the second memory are both accessible to the compute die.

The claimed PCB assembly includes a PCB, a first memory, and a semiconductor package. The first memory is mounted on the PCB. The semiconductor package includes a package substrate, an interposer, a second memory, and a compute die. The package substrate is mounted on the PCB. The interposer is mounted on the package substrate. The second memory is mounted on the interposer. The first memory and the second memory are both accessible to the compute die.

### Brief Description of the Drawings

In the following, the invention is further illustrated by way of example, taking reference to the accompanying drawings. Thereof
FIG. 1 is a top view of a semiconductor package according to an embodiment of the present invention,
FIG. 2 is a cross-section view along line A-A' of the semiconductor package shown in FIG. 1,
FIG. 3 is a top view of a semiconductor package according to an embodiment of the present invention,
FIG. 4 is a cross-section view along line B-B' of the semiconductor package shown in FIG. 3,
FIG. 5 is a top view of a PCB assembly according to an embodiment of the present invention, and
FIG. 6 is a cross-section view along line C-C' of the PCB assembly shown in FIG. 5.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

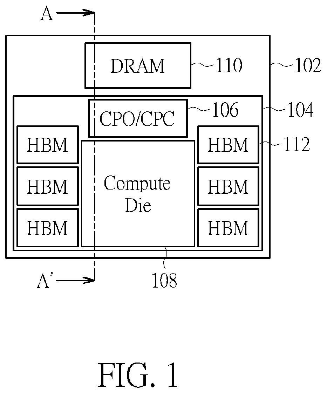

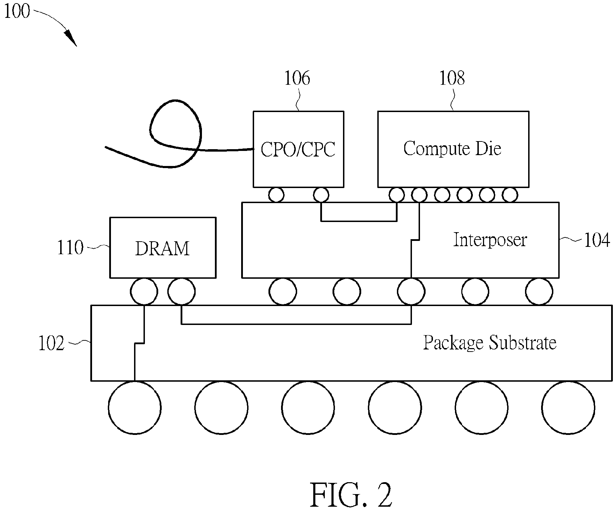

Please refer to FIG. 1 in conjunction with FIG. 2. FIG. 1 is a top view of a semiconductor package according to an embodiment of the present invention. FIG. 2 is a cross-section view along line A-A' of the semiconductor package shown in FIG. 1. The semiconductor package 100 includes a package substrate (e.g., organic substrate) 102, an interposer 104, and a plurality of components 106, 108, 110 and 112. The interposer 104 is mounted on the package substrate 102. In this embodiment, the component 106 is an optical chiplet (i.e., a co-packaged optics (CPO) chiplet) or a co-packaged connector (CPC); the component 108 is a compute die such as a graphics processing unit (GPU) die, a central processing unit (CPU) die, a system-on-a-chip (SoC) die, or any datacenter processor die; the component 112 is an HBM; and the component 110 is a DRAM such as a low power double data rate (LPDDR) memory. The components 106, 108, 112 are mounted on the interposer 104.

In this embodiment, the component (e.g., CPO chiplet or CPC) 106 is located on an edge of the interposer 104. The component (e.g., DRAM) 110 is mounted on the package substrate 102. In this embodiment, the component (e.g., DRAM) 110 on the package substrate 102 is adjacent to the edge of the interposer 104. As illustrated in FIG. 2, the component (e.g., DRAM) 110 and the component (e.g., CPO chiplet or CPC) 106 are offset in a vertical direction and arranged side-by-side in a horizontal direction. As illustrated in FIG. 1, the component (e.g., DRAM) 110 and the component (e.g., CPO chiplet or CPC) 106 are placed side-by-side in a north-south (NS) direction of the semiconductor package 100 (particularly, the NS direction of the top view of the semiconductor package 100). Specifically, the component (e.g., DRAM) 110 is placed at the north of the component (e.g., CPO chiplet or CPC) 106.

In a case where the component 106 is an optical chiplet (i.e., CPO chiplet), the component 106 is electrically connected to the compute die 108 through the interposer 104, and includes optical engine(s) for transmitting/receiving IO signals through the fiber. Hence, the component 106 does not require IO signal routing in the package substrate 102. In other words, using the optical chiplet (i.e., CPO chiplet) can bypass traces in a package substrate that are previously needed by an IO chiplet, thereby releasing routing areas of the package substrate that are previously reserved for IO signal routing.

In another case where the component 106 is a CPC, the component 106 is electrically connected to the compute die 108 through the interposer 104, and allows transmission/receipt of IO signals through the copper cable. Hence, the component 106 does not require IO signal routing in the package substrate 102. In other words, using the CPC can bypass traces in a package substrate that are previously needed by an IO chiplet, thereby releasing routing areas of the package substrate that are previously reserved for IO signal routing.

In this embodiment, the component (e.g., CPO chiplet or CPC) 106 takes the place of an IO chiplet. With the aid of the component (e.g., CPO chiplet or CPC) 106, the package substrate 102 is free of IO signal routing needed by the IO chiplet, allowing the placement of an additional component (e.g., LPDDR memory) on a substrate area adjacent to the interposer 104 (particularly, a substrate area adjacent to interposer's edge on which the component (e.g., CPO chiplet or CPC) 106 is located) under the same package size.

Regarding the embodiment shown in FIG. 1 and FIG. 2, the additional component 110 mounted on the package substrate 102 is a DRAM (e.g., LPDDR memory) for memory expansion, where DRAM(s) on package substrate 102 and HBM(s) on interposer 104 are accessible to the compute die 108 on interposer 104. However, this is for illustrative purposes only, and is not meant to be a limitation of the present invention. In some embodiments of the present invention, the additional component 110 mounted on the package substrate 102 may be a chiplet with a designated logic function.

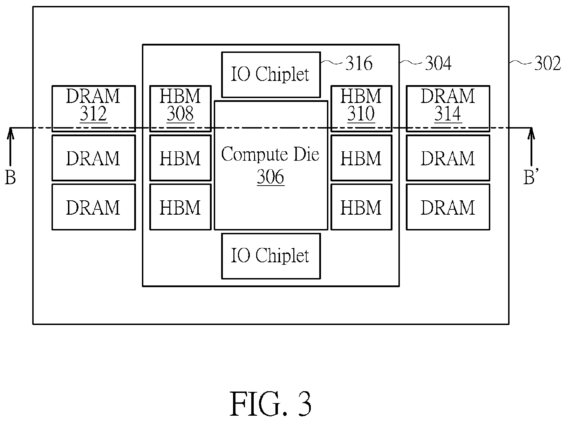

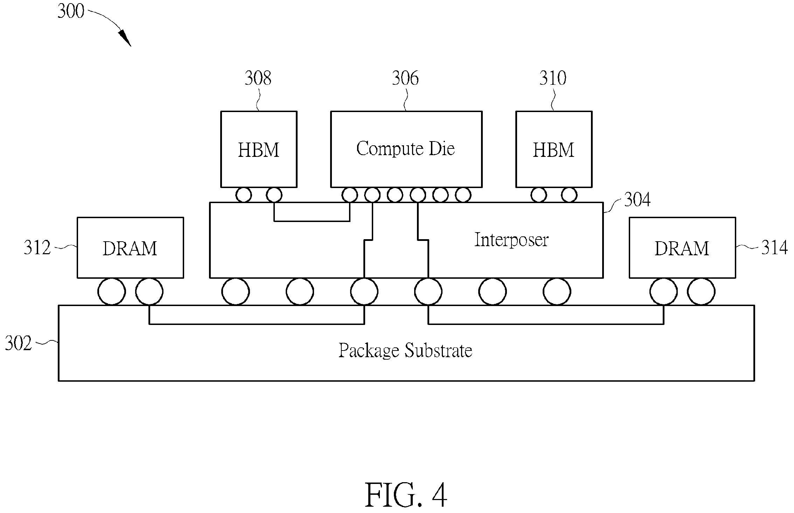

As shown in FIG. 1 and FIG. 2, the additional component 110 mounted on the package substrate 102 is a DRAM (e.g., LPDDR memory) for memory expansion. In practice, any semiconductor package design using such a memory stacking scheme for memory expansion falls within the scope of the present invention. Please refer to FIG. 3 in conjunction with FIG. 4. FIG. 3 is a top view of a semiconductor package according to an embodiment of the present invention. FIG. 4 is a cross-section view along line B-B' of the semiconductor package shown in FIG. 3. The semiconductor package 300 includes a package substrate 302, an interposer 304, and a plurality of components 306, 308, 310, 312, 314, 316. The interposer 304 is mounted on the package substrate 302. In this embodiment, the component 306 is a compute die such as a GPU die, a CPU die, an SoC die, or any datacenter processor die; each of the components 308, 310 is an HBM such as an HBM4e; each of the components 312, 314 is a DRAM such as an LPDDR memory; and the component 316 is an IO chiplet. The components 306, 308, 310, 316 are mounted on the interposer 104. The components 312, 314 are mounted on the package substrate 302.

The memory components can be stacked in the same direction (e.g., east-west (EW) direction). As shown in FIG. 4, the component (e.g., DRAM) 312 and the component (e.g., HBM) 308 are offset in a vertical direction and arranged side-by-side in a horizontal direction, and the component (e.g., HBM) 310 and the component (e.g., DRAM) 314 are offset in a vertical direction and arranged side-by-side in a horizontal direction. As shown in FIG. 3, the components (e.g., DRAMs) 312, 314 and the components (e.g., HBMs) 308, 310 are stacked in an EW direction of the semiconductor package 300 (particularly, the EW direction of the top view of the semiconductor package 300), and the components (e.g., DRAMs) 312 and 314 are stacked with the components (e.g., HBMs) 308 and 310, respectively.

In this embodiment, the additional components 312, 314 mounted on the package substrate 302 are DRAMs (e.g., LPDDR memories each having a compression attached memory module (CAMM) form factor or a dual in-line memory module (DIMM) form factor) for memory expansion, where DRAM(s) on package substrate 302 and HBM(s) on interposer 304 are accessible to the compute die 306 on interposer 304. However, this is for illustrative purposes only, and is not meant to be a limitation of the present invention. In practice, the present invention has no limitations on the memory combination used by the memory expansion. In some embodiments of the present invention, the components 312, 314 mounted on the package substrate 302 may be any available memories such as HBMs or LPDDR memories, depending upon actual design considerations. In some embodiments of the present invention, the components 308, 310 mounted on the interposer 304 may be any available memories such as HBMs or LPDDR memories, depending upon actual design considerations.

Regarding the embodiment shown in FIG. 3 and FIG. 4, the additional components (e.g., DRAMs) 312, 314 are mounted on the package substrate 302 for memory expansion, where DRAM(s) on package substrate 302 and HBM(s) on interposer 304 are accessible to the compute die 306 on interposer 304. However, this is for illustrative purposes only, and is not meant to be a limitation of the present invention. In some embodiments of the present invention, the additional component (e.g., DRAMs) may be mounted on a PCB.

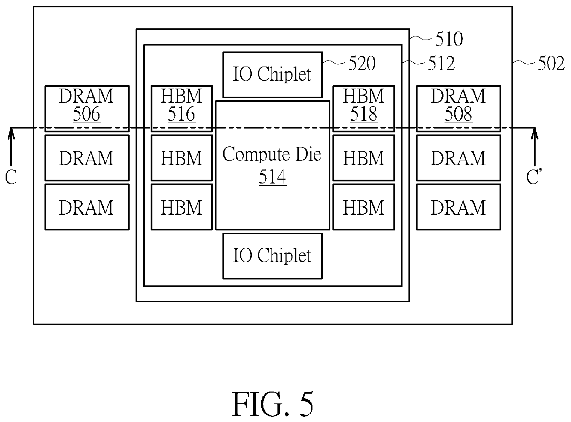

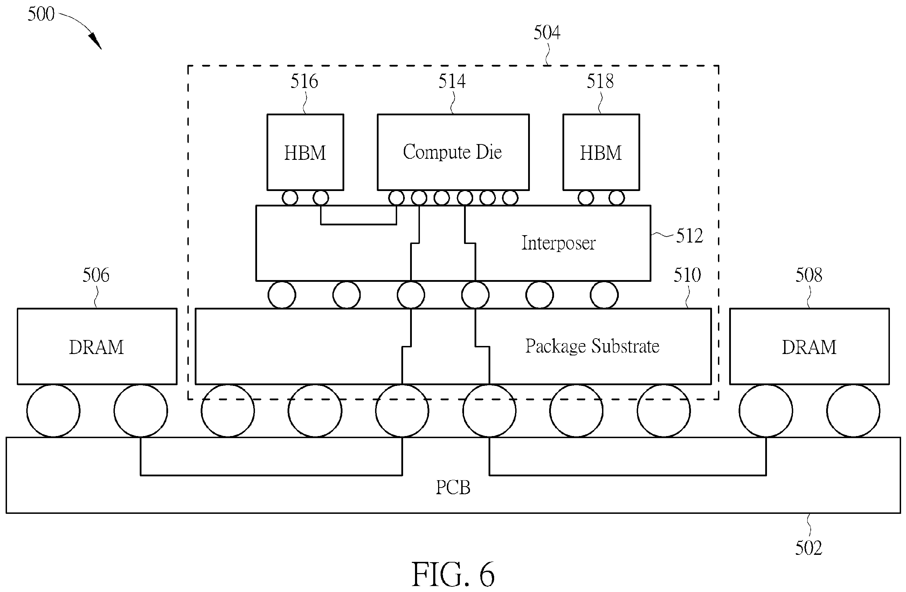

Please refer to FIG. 5 in conjunction with FIG. 6. FIG. 5 is a top view of a PCB assembly according to an embodiment of the present invention. FIG. 6 is a cross-section view along line C-C' of the PCB assembly shown in FIG. 5. The PCB assembly 500 includes a PCB 502, a semiconductor package 504, and a plurality of components 506, 508. The semiconductor package 504 includes a package substrate 510, an interposer 512, and a plurality of components 514, 516, 518, 520. The interposer 512 is mounted on the package substrate 510. In this embodiment, the component 514 is a compute die such as a GPU die, a CPU die, an SoC die, or any datacenter processor die; each of the components 516, 518 is an HBM such as an HBM4e; each of the components 506, 508 is a DRAM such as an LPDDR memory; and the component 520 is an IO chiplet. The components 514, 516, 518, 520 are mounted on the interposer 512. The components 506, 508 are mounted on the PCB 502.

The memory components can be stacked in the same direction (e.g., EW direction). As shown in FIG. 6, the component (e.g., DRAM) 506 and the component (e.g., HBM) 516 are offset in a vertical direction and arranged side-by-side in a horizontal direction, and the component (e.g., HBM) 518 and the component (e.g., DRAM) 508 are offset in a vertical direction and arranged side-by-side in a horizontal direction. As shown in FIG. 5, the components (e.g., DRAMs) 506, 508 and the components (e.g., HBMs) 516, 518 are stacked in an EW direction of the PCB assembly 500 (particularly, the EW direction of the top view of the PCB assembly 500).
In this embodiment, the additional components 506, 508 mounted on the PCB 502 are DRAMs (e.g., LPDDR memories each having a CAMM/DIMM form factor) for memory expansion, where DRAM(s) on PCB 502 and HBM(s) on interposer 512 are accessible to the compute die 514 on interposer 512. However, this is for illustrative purposes only, and is not meant to be a limitation of the present invention. In practice, the present invention has no limitations on the memory combination used by the memory expansion. In some embodiments of the present invention, the components 506, 508 mounted on the PCB 502 may be any available memories such as HBMs or LPDDR memories, depending upon actual design considerations. In some embodiments of the present invention, the components 516, 518 mounted on the interposer 512 may be any available memories such as HBMs or LPDDR memories, depending upon actual design considerations.

## Claims

1. A semiconductor package (100) **characterized by**:
a package substrate (102);
an interposer (104), mounted on the package substrate (102);
a first component (106), mounted on the interposer, wherein the first component (106) is located on an edge of the interposer (104), and the first component (106) is an optical chiplet or a co-packaged connector; and
a second component (110), mounted on the package substrate (102), wherein the second component (110) on the package substrate (102) is adjacent to the edge of the interposer (104).

2. The semiconductor package (100) of claim 1, **characterized in that** the second component (110) is a dynamic random access memory.

3. The semiconductor package (100) of claim 2, **characterized in that** the DRAM is a low power double data rate memory.

4. A semiconductor package (300) **characterized by**:
a package substrate (302);
an interposer (304), mounted on the package substrate (302);
a first memory (312, 314), mounted on the package substrate (302);
a second memory (308, 310), mounted on the interposer (304); and
a compute die (306), wherein the first memory (312, 314) and the second memory (308, 310) are both accessible to the compute die (306).

5. A printed circuit board, PCB, assembly (500) **characterized by**:
a PCB (502);
a first memory (506, 508), mounted on the PCB (502); and
a semiconductor package (504), comprising:
a package substrate (510), mounted on the PCB (502);
an interposer (512), mounted on the package substrate (510);
a second memory (516, 518), mounted on the interposer (512); and
a compute die (514), wherein the first memory (506, 508) and the second memory (516, 518) are both accessible to the compute die (514).

6. The semiconductor package (300) of claim 4 or the PCB assembly (500) of claim 5, **characterized in that** the first memory (312, 314, 506, 508) is a dynamic random access memory.

7. The semiconductor package (300) of claim 4 or the PCB assembly (500) of claim 5, **characterized in that** the first memory (312, 314, 506, 508) is a high bandwidth memory.

8. The semiconductor package (300) of claim 4 or the PCB assembly (500) of claim 5, **characterized in that** the first memory (312, 314, 506, 508) is a low power double data rate memory.

9. The semiconductor package (300) of claim 4 or the PCB assembly (500) of claim 5, **characterized in that** the second memory (308, 310, 516, 518) is a dynamic random access memory.

10. The semiconductor package (300) of claim 4 or the PCB assembly (500) of claim 5, **characterized in that** the second memory (308, 310, 516, 518) is a high bandwidth memory.

11. The semiconductor package (300) of claim 4 or the PCB assembly (500) of claim 5, **characterized in that** the second memory (308, 310, 516, 518) is a low power double data rate memory.
